(19) **Europäisches Patentamt**
**European Patent Office**
**Office européen des brevets**

(11) **EP 1 100 192 B1**

(12) **EUROPÄISCHE PATENTSCHRIFT**

(45) Veröffentlichungstag und Bekanntmachung des Hinweises auf die Patenterteilung:
**09.04.2008 Patentblatt 2008/15**

(51) Int Cl.:
*H03B 19/12* (2006.01)   *H03B 19/14* (2006.01)
*H03B 21/04* (2006.01)

(21) Anmeldenummer: **00120424.7**

(22) Anmeldetag: **18.09.2000**

(54) **Empfängeroszillator für verschiedene Frequenzbänder**

Oscillator for multiband receiver

Oscillateur pour récepteur à plusieurs bandes de fréquence

(84) Benannte Vertragsstaaten:
**DE FR GB**

(30) Priorität: **28.09.1999 DE 19946494**

(43) Veröffentlichungstag der Anmeldung:
**16.05.2001 Patentblatt 2001/20**

(73) Patentinhaber: **Infineon Technologies AG**
**81669 München (DE)**

(72) Erfinder:
• **Stepp, Richard**
**80796 München (DE)**
• **Dietze, Andreas**
**83626 Valley (DE)**

(74) Vertreter: **Epping - Hermann - Fischer**
**Patentanwaltsgesellschaft mbH**
**Ridlerstrasse 55**
**80339 München (DE)**

(56) Entgegenhaltungen:
FR-A- 2 576 470       GB-A- 2 024 546
US-A- 4 211 975

• **CAMPBELL P M ET AL: "A very-wide bandwidth digital VCO implemented in GaAs HBTs using frequency multiplication and division" GALLIUM ARSENIDE INTEGRATED CIRCUIT (GAAS IC) SYMPOSIUM, 1995. TECHNICAL DIGEST 1995., 17TH ANNUAL IEEE SAN DIEGO, CA, USA 29 OCT.-1 NOV. 1995, NEW YORK, NY, USA,IEEE, US, 29. Oktober 1995 (1995-10-29), Seiten 311-314, XP010196783 ISBN: 0-7803-2966-X**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen Empfänger für verschiedene Frequenzbänder. Der Empfänger ist insbesondere für ein Autoradio geeignet, das weltweit für alle vorkommenden Frequenzen eingesetzt werden kann.

Mit Empfängern, insbesondere Empfängern in Autoradios, sollen verschiedene Frequenzbänder, wie beispielsweise Langwelle, Mittelwelle, Kurzwelle oder Ultrakurzwelle empfangen werden können. Aus Kostengründen ist es nötig, bei allen Frequenzbändern mit nur einem Oszillator und einer nicht geschalteten Peripherie des Oszillators auszukommen. Soll der Empfänger weltweit einsetzbar sein, treten insbesondere im Ultrakurzwellenbereich, im folgenden auch als UKW-Bereich bezeichnet, Schwierigkeiten bezüglich des Gleichlaufs, des Störabstands, des Fang- und des Rastverhaltens auf, wenn die Frequenzbänder relativ weit auseinander liegen und nicht mittels eines ganzzahligen Teilers beispielsweise durch 2, 4, 6 usw. realisierbar sind. Im UKW-Bereich liegt der Empfangsfrequenzbereich in Europa zwischen 87,5 MHz und 108 MHz (= CCIR-Band = Comité Consultatif International des Radiocommunications). Da in Europa in der Regel ein High-Side-Oszillator verwendet wird, ergeben sich die Oszillatorfrequenzen bei einer Zwischenfrequenz von 10,7 MHz zu 98,2 MHz bis 118,7 MHz. In Japan liegt das UKW-Band zwischen 76 MHz und 90 MHz. Der in Japan in der Regel verwendete Low-Side-Oszillator muß bei einer Zwischenfrequenz von ebenfalls 10,7 MHz damit zwischen 65,3 MHz und 79,3 MHz schwingen. Die Low-Side-Variante ist in Japan aus Gründen der Spiegelselektion erforderlich. Soll der Empfänger sowohl für das europäische als auch für das japanische UKW-Band betreibbar sein und nur einen einzigen Oszillator aufweisen, so muß der Oszillator zwischen 65,3 MHz und 118,7 MHz abstimmbar sein. Die Variation beträgt hier

118,7 MHz : 65,3 MHz = 1,82.

Ein Oszillator mit einem derart großen Abstimmbereich ist nicht ohne weiteres realisierbar.

In der Literaturstelle: Gallium Arsenide Integrated Circuit Symposium, 1995, Technical Digest 1995, 17th Annual IEEE San Diego, CA, USA, 29. Oktober bis 1. November 1995, New York, NY, USA, IEEE, Seiten 311 bis 314 ist ein spannungsgesteuerter digitaler Hochgeschwindigkeitsoszillator beschrieben, der in einem Frequenzbereich zwischen 0,5 bis 13,66 GHz betrieben wird. Der Oszillator weist einen Frequenzmultiplizierer auf, der ausgangsseitig das Doppelte oder das Vierfache der Eingangsfrequenz liefert. Über Multiplexer gesteuert kann ein Frequenzteiler nachgeschaltet werden, der die Frequenz um 1/2, 1/4 oder 1/8 teilt. Der Frequenzteiler besteht aus drei Toggle-Flip-Flops.

Die Anwendung eines einstellbaren Oszillators ist in der US-A-4 211 975 beschrieben. Der dort gezeigte Oszillator weist Teiler und Multiplizierer auf, die einstellbar sind und in Reihe zueinander geschaltet sind.

Eine Aufgabe der Erfindung ist es, einen Empfänger anzugeben, der für verschiedene Frequenzbänder geeignet ist und mit einem Oszillator auskommt.

Die Aufgabe wird erfindungsgemäß durch einen Empfänger für verschiedene Frequenzbänder mit den in Patentanspruch 1 angegebenen Merkmalen gelöst.

Weitere vorteilhafte Ausgestaltungen des erfindungsgemäßen Empfängers, insbesondere für verschiedene weitere Frequenzbänder, sind in den abhängigen Patentansprüchen angegeben.

Der erfindungsgemäße Empfänger für verschiedene Frequenzbänder weist einen Oszillator auf, der ein Oszillatorsignal mit einer Oszillatorfrequenz erzeugt. Weiterhin ist ein Frequenzteiler mit einem einstellbaren reellen Teilerwert vorgesehen, der dem Oszillator nachgeschaltet ist und die Oszillatorfrequenz durch den reellen Teilerwert teilt. Der Frequenzteiler weist einen ersten Multiplizierer mit einem ersten einstellbaren ganzzahligen Multiplikator und einen ersten Teiler mit einem ersten einstellbaren ganzzahligen Teilerwert auf. Der erste Multiplizierer und der erste Teiler sind in Serie geschaltet.

Es können ein oder mehrere weitere Multiplizierer mit jeweils ganzzahligem Multiplikator und ein oder mehrere weitere Teiler mit jeweils ganzzahligem Teilerwert vorgesehen sein. Der oder die weiteren Multiplizierer und der oder die weiteren Teiler sind in Serie geschaltet. Dadurch ist eine größere Menge an Teilerwerten erzeugbar.

Vorteilhafterweise ist der Multiplizierer ein Mischer.

Vorteilhafterweise ist der Teiler ein Zähler.

Der Oszillator ist vorteilhafterweise spannungsgesteuert.

Wenn der Oszillator bei einer Oszillatorfrequenz von 97,7 MHz bis 118,7 MHz betrieben wird, ist der ganzzahlige Teilerwert vorteilhafterweise 1 und der ganzzahlige Multiplikatorwert ebenfalls 1.

Wird der Oszillator bei einer Oszillatorfrequenz von 97,95 MHz bis 120,45 MHz betrieben, beträgt der ganzzahlige Teilerwert 3 und der ganzzahlige Multiplikatorwert vorteilhafterweise 2.

Wird der Oszillator bei einer Oszillatorfrequenz von 114,75 MHz bis 127,05 MHz betrieben, beträgt der ganzzahlige Teilerwert 3 und der ganzzahlige Multiplikatorwert vorteilhafterweise 2.

Gemäß Patentanspruch 9 ist es von Vorteil, bei einer Oszillatorfrequenz von 108,5 MHz bis 109,82 MHz den ganzzahligen Teilerwert = 10 und den ganzzahligen Multiplikatorwert = 1 zu setzen.

Vorteilhafterweise findet der Empfänger Verwendung in einem Radio.

Die Erfindung wird im folgenden anhand von drei Figuren.weiter erläutert:

Figur 1    zeigt eine erste Ausführungsform der Erfindung,

Figur 2    zeigt eine zweite Ausführungsform der Erfindung und

Figur 3    zeigt eine dritte Ausführungsform der Erfindung.

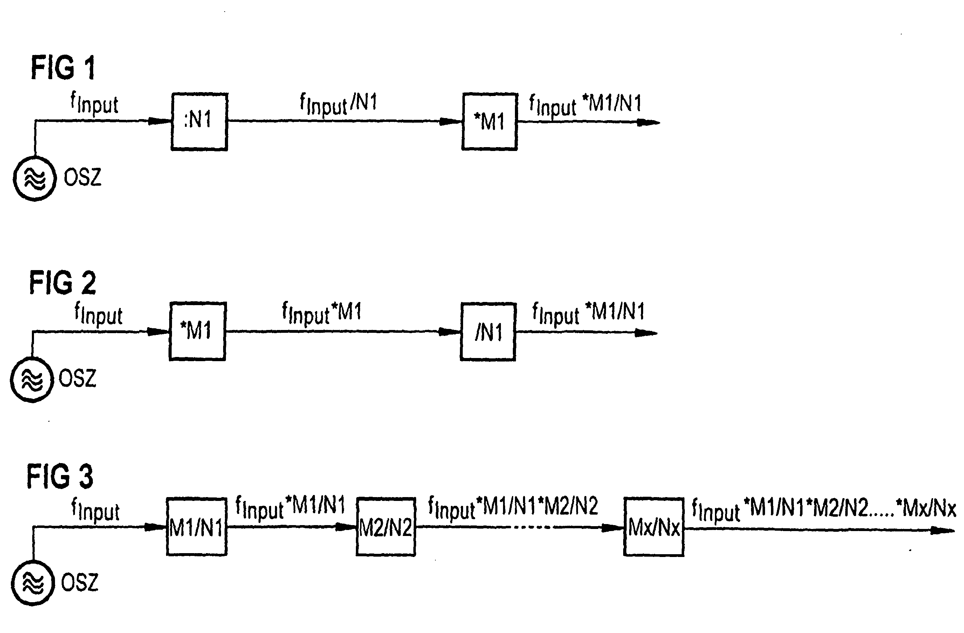

Bei der in Figur 1 gezeigten Ausführungsform der Erfindung ist ein Oszillator OSZ vorgesehen, der ein Oszillatorsignal mit einer Oszillatorfrequenz finput erzeugt, welches einem ersten Teiler mit dem Teilerwert N1 zugeführt wird. Der Teilerwert N1 ist dabei eine ganze Zahl. Der Teiler erzeugt an seinem Ausgang ein Ausgangssignal mit der Frequenz finput : N1. Das Signal mit der Frequenz finput : N1 wird einem Multiplizierer mit dem Multipliziererwert M1 zugeführt, der daraus ein Signal mit einer Frequenz $\mathrm{finput} \cdot \dfrac{M1}{N1}$ erzeugt.

Wählt man den Teilerwert N1 = 3 und den Multiplikatorwert M1 = 2, so ergibt sich ein Teilerwert TW = 1,5.

Möchte man den Empfänger im europäischen UKW-Band von 87 MHz bis 108 MHz betreiben, so stellt man den ganzzahligen Teilerwert N1 auf den Wert 1 und den ganzzahligen Multiplikatorwert M1 ebenfalls auf den Wert 1.

Soll der Empfänger hingegen im japanischen UKW-Frequenzband betrieben werden, so ist der ganzzahlige Teilerwert N1 auf den Wert 3 und der ganzzahlige Multiplikatorwert M1 auf den Wert 2 einzustellen.

Damit ergibt sich für das europäische UKW-Frequenzband ein Oszillatorfrequenzbereich von 97,7 bis 118,7 MHz und für das japanische UKW-Frequenzband von 76 MHz bis 91 MHz ein Oszillatorfrequenzbereich von 97,95 bis 120,45 MHz. Somit beträgt die Variation nurmehr 118,95 MHz :97,95 MHz = 1,21. Dies stellt gegenüber der in der Beschreibungseinleitung angegebenen Variation von 1,82 eine deutliche Verbesserung dar.

In der folgenden Tabelle ist dargestellt, bei welchem Frequenzband (Empfangsfrequenz) welcher Teilerwert TW eingestellt werden muß.

Frequenztabelle

| Band | Modulationsart | Empfangsfrequenz | Teilerwert | Oszillatorfrequenz | PLL Referenzfrequenz |
|------|----------------|------------------|------------|--------------------|----------------------|
|      |                | MHz              | TW         | MHz                | kHz                  |
| FM   | FM             | 87...108         | 1          | 97,7...118,7       | 100                  |
| FM   | FM             | 76...91          | 1,5        | 97,95...120,45     | 150                  |
| FM   | FM             | 65,8...74        | 1,5        | 114,75...127,05    | 150                  |
| WB   | FM             | 162,4...162,55   | 1          | 111,6...111,75     | 25                   |
| LW   | AM             | 0,15...0,282     | 10         | 108,5...109,82     | 10                   |
| MW   | AM             | 0,53...1,71      | 10         | 112,3...124,1      | 10                   |
|      | AM             | 0,513...1,62     | 10         | 112,13...123,2     | 10                   |
| SW   |                |                  |            |                    |                      |
| 120m | AM             | 2,3...2,5        | 8          | 105,0...105,6      | 10                   |
| 90m  | AM             | 3,2...3,4        | 8          | 111,2...112,8      | 10                   |
| 75m  | AM             | 3,9...4,0        | 8          | 116,8...117,6      | 10                   |
| 60m  | AM             | 4,75...5,06      | 8          | 123,6...126,08     | 10                   |
| 49m  | AM             | 5,9...6,2        | 6          | 99,6...101,4       | 10                   |
| 41m  | AM             | 7,1...7,35       | 6          | 106,8...108,3      | 10                   |
| 31m  | AM             | 9,4...9,9        | 6          | 120,6...123,6      | 10                   |
| 25m  | AM             | 11,6...12,1      | 4          | 89,2...91,2        | 10                   |
| 22m  | AM             | 13,57...13,87    | 4          | 97,08...98,28      | 10                   |
| 19m  | AM             | 15,1...15,8      | 4          | 103,2...106,0      | 10                   |

(fortgesetzt)

| Band | Modulationsart | Empfangsfrequenz | Teilerwert | Oszillatorfrequenz | PLL Referenzfrequenz |
|------|----------------|------------------|------------|--------------------|--------------------|
|      |                | MHz              | TW         | MHz                | kHz                |
| 16m  | AM             | 17,48...17,9     | 4          | 112,72...114,4     | 10                 |
| 15m  | AM             | 18,9...19,02     | 4          | 118,4...118,88     | 10                 |
| 13m  | AM             | 21,45...21,85    | 4          | 128,6...130,2      | 10                 |
| 11m  | AM             | 25,6...26,1      | 6          | 89,4...92,4        | 10                 |

Die Anordnung gemäß Figur 2 entspricht im wesentlichen der in Figur 1. Gegenüber der in Figur 1 gezeigten Anordnung wird jedoch das Oszillatorsignal mit der Oszillatorfrequenz finput zuerst dem Multiplizierer mit dem ganzzahligen Multiplikatorwert M1 zugeführt, der daraus ein Signal mit der Frequenz finput · M1 erzeugt. Dieses Signal mit der Frequenz finput · M1 wird dann dem Teiler mit dem ganzzahligen Teilerwert N1 zugeführt, der an seinem Ausgang ein Signal mit der Frequenz $finput \cdot \dfrac{M1}{N1}$ zur Verfügung stellt, welches dem in Figur 1 gezeigten Ausgangssignal entspricht.

Das in Figur 3 gezeigte Ausführungsbeispiel hat den Vorteil, daß eine größere Menge reeller Teilerwerte TW durch eine Hintereinanderschaltung mehrerer Multiplizierer und Teiler erzeugt werden kann. Bei der in Figur 3 gezeigten Ausführungsform ist jeder Multiplizierer mit einem ganzzahligen Multiplikatorwert mit einem Teiler mit einem ganzzahligen Teilerwert zusammengefaßt. So ergibt sich am Ausgang der ersten Multiplizierer-Teilerstufe ein Ausgangssignal mit der Ausgangsfrequenz

$$finput \cdot \frac{M1}{N1},$$

am Ausgang der zweiten Multiplizierer-Teilerstufe ein Signal mit der Ausgangsfrequenz

$$finput \cdot \frac{M1}{N1} \cdot \frac{M2}{N2}$$

und am Ausgang der xten Multiplizierer-Teilerstufe ein Ausgangssignal mit der Ausgangsfrequenz

$$finput \cdot \frac{M1}{N1} \cdot \frac{M2}{N2} \cdots \frac{Mx}{Nx}.$$

Die serielle Aneinanderreihung der Multiplizierer und Teiler kann prinzipiell auf beliebige Art und Weise erfolgen. Zu beachten ist jedoch, daß die am Ausgang eines jeden Multiplizierers beziehungsweise Teilers auftretenden Frequenzen noch im Bereich des Handhabbaren liegen. Werden beispielsweise mehrere Multiplizierer direkt hintereinander geschaltet, so ergibt sich am Ausgang des letzten Multiplizierers eine möglicherweise nicht mehr handhabbare Frequenz. Ist dies der Fall, so sollte die in Figur 3 gezeigte Ausführungsform bevorzugt werden.

Als Teiler können beispielsweise Zähler verwendet werden, die mit einem bestimmten Wert vorgeladen werden, der dann dem ganzzahligen Teilerwert N1, N2 oder Nx entspricht.

Als Multiplizierer kann beispielsweise ein Mischer verwendet werden. Wird an die beiden Mischereingänge jeweils das gleiche Signal angelegt, so erhält man am Ausgang des Mischers ein Signal mit der doppelten Eingangsfrequenz. Der ganzzahlige Multiplikatorwert beträgt in diesem Fall 2.

Die für die Erfindung verwendbaren Multiplizierer und Teiler sind jedoch nicht auf Mischer und Zähler beschränkt, sondern es können auch andere für Multiplikatoren und Teiler bekannte Schaltungsanordnungen verwendet werden.

Bezugszeichenliste

| | |
|---|---|
| OSZ | Oszillator |
| finput | Oszillatorfrequenz |
| N1, N2, Nx | ganzzahliger Teilerwert |
| M1, M2, Mx | ganzzahliger Multiplikatorwert |
| TW | reeller Teilerwert |

**Patentansprüche**

1.  Empfänger für verschiedene Empfangs-Frequenzbänder, bei dem ein Oszillator (OSZ) vorgesehen ist, der ein Oszillatorsignal mit einer Oszillatorfrequenz (finput) erzeugt,
    bei dem ein Frequenzteiler mit einem einstellbaren reellen Teilerwert (TW) vorgesehen ist, der dem Oszillator nachgeschaltet ist und die Oszillatorfrequenz (finput) durch den reellen Teilerwert (TW) teilt,
    **dadurch gekennzeichnet, dass**: der Frequenzteiler einen ersten Multiplizierer mit einem ersten einstellbaren ganzzahligen Multiplikatorwert (M1) aufweist und der Frequenzteiler einen ersten Teiler mit einem ersten einstellbaren ganzzahligen Teilerwert (N1) aufweist, wobei der erste Multiplizierer und der erste Teiler in Serie geschaltet sind,
    dann, wenn der Empfänger bei einer Empfangsfrequenz im Bereich von 87 MHz bis 108 MHz betrieben wird, der Oszillator bei einer Oszillatorfrequenz im Bereich von 97,7 MHz bis 118,7 MHz betrieben wird und der ganzzahlige Teilerwert (N1) auf eins und der ganzzahlige Multiplikatorwert (M1) auf eins eingestellt ist,
    dann, wenn der Empfänger bei einer Empfangsfrequenz im Bereich von 76 MHz bis 91 MHz betrieben wird, der Oszillator bei einer Oszillatorfrequenz im Bereich von 97,95 MHz bis 120,45 MHz betrieben wird und der ganzzahlige Teilerwert (N1) auf drei und der ganzzahlige Multiplikatorwert (M1) auf zwei eingestellt ist,
    dann, wenn der Empfänger bei einer Empfangsfrequenz im Bereich von 65,8 MHz bis 74 MHz betrieben wird, der Oszialltor bei einer Oszillatorfrequenz im Bereich von 114,75 MHz bis 127,05 MHz betrieben wird und der ganzzahlige Teilerwert (N1) auf drei und der ganzzahlige Multiplikatorwert (M1) auf zwei eingestellt ist,
    dann, wenn der Empfänger bei einer Empfangsfrequenz im Bereich von 0,15 MHz bis 0,282 MHz betrieben wird, der Oszillator bei einer Oszillatorfrequenz im Bereich von 108,5 MHz bis 109,82 MHz betrieben wird und der ganzzahlige Teilerwert (N1) auf zehn und der ganzzahlige Multiplikatorwert (M1) auf eins eingestellt ist,
    dann, wenn der Empfänger bei einer Empfangsfrequenz im Bereich von 0,53 MHz bis 1,71 MHz betrieben wird, der Oszillator bei einer Oszillatorfrequenz im Bereich von 112,3 MHz bis 124,1 MHz betrieben wird und der ganzzahlige Teilerwert (N1) auf zehn und der ganzzahlige Multiplikatorwert (M1) auf eins eingestellt ist,
    dann, wenn der Empfänger bei einer Empfangsfrequenz im Bereich von 0,513 MHz bis 1,62 MHz betrieben wird, der Oszillator bei einer Oszillatorfrequenz im Bereich von 112,13 MHz bis 123,2 MHz betrieben wird und der ganzzahlige Teilerwert (N1) auf zehn und der ganzzahlige Multiplikatorwert (M1) auf eins eingestellt ist.

2.  Empfänger nach Anspruch 1
    bei dem dann, wenn der Empfänger bei einer Empfangsfrequenz im Bereich von 2,3 MHz bis 5,06 MHz betrieben wird, der Oszillator bei einer Oszillatorfrequenz im Bereich von 105,0 MHz bis 126,08 MHz betrieben wird und der ganzzahlige Teilerwert (N1) auf acht und der ganzzahlige Multiplikatorwert (M1) auf eins eingestellt ist,
    bei dem dann, wenn der Empfänger bei einer Empfangsfrequenz im Bereich von 5,9 MHz bis 9,9 MHz betrieben wird, der Oszillator bei einer Oszillatorfrequenz im Bereich von 99,6 MHz bis 123,6 MHz betrieben wird und der ganzzahlige Teilerwert (N1) auf sechs und der ganzzahlige Multiplikatorwert (M1) auf eins eingestellt ist,
    bei dem dann, wenn der Empfänger bei einer Empfangsfrequenz im Bereich von 11,6 MHz bis 21,85 MHz betrieben wird, der Oszillator bei einer Oszillatorfrequenz im Bereich von 89,2 MHz bis 130,2 MHz betrieben wird und der ganzzahlige Teilerwert (N1) auf vier und der ganzzahlige Multiplikatorwert (M1) auf eins eingestellt ist,
    bei dem dann, wenn der Empfänger bei einer Empfangsfrequenz im Bereich von 25,6 MHz bis 26,1 MHz betrieben wird, der Oszillator bei einer Oszillatorfrequenz im Bereich von 89,4 MHz bis 92,4 MHz betrieben wird und der ganzzahlige Teilerwert (N1) auf sechs und der ganzzahlige Multiplikatorwert (M1) auf eins eingestellt ist,

3.  Empfänger nach Anspruch 1 oder 2,
    bei dem der Multiplizierer ein Mischer ist.

4.  Empfänger nach einem der Ansprüche 1 bis 3,

bei dem der Teiler ein Zähler ist.

5. Empfänger nach einem der Ansprüche 1 bis 4,
   bei dem der Oszillator ein spannungssteuerbarer Oszillator ist.

6. Verwendung eines Empfängers nach einem der Ansprüche 1 bis 5 in einem Radio.

**Claims**

1. Receiver for different reception frequency bands, for which an oscillator (OSZ) is provided, which produces an oscillator signal at an oscillator frequency (finput),
   in which a frequency divider with a variable real divisor (TW) is provided, follows the oscillator and divides the oscillator frequency (finput) by the real divisor (TW),
   **characterized in that**
   the frequency divider has a first multiplier with a first variable integer multiplier value (M1) and the frequency divider has a first divider with a first variable integer divisor (N1), with the first multiplier and the first divider being connected in series,
   when the receiver is operated at a reception frequency in the range from 87 MHz to 108 MHz, the oscillator is operated at an oscillator frequency in the range from 97.7 MHz to 118.7 MHz, and the integer divisor (N1) is set to unity, and the integer multiplier value (M1) is set to unity,
   when the receiver is operated at a reception frequency in the range from 76 MHz to 91 MHz, the oscillator is operated at an oscillator frequency in the range from 97.95 MHz to 120.45 MHz, and the integer divisor (N1) is set to three, and the integer multiplier value (M1) is set to two,
   when the receiver is operated at a reception frequency in the range from 65.8 MHz to 74 MHz, the oscillator is operated at an oscillator frequency in the range from 114.75 MHz to 127.05 MHz, and the integer divisor (N1) is set to three, and the integer multiplier value (M1) is set to two,
   when the receiver is operated at a reception frequency in the range from 0.15 MHz to 0.282 MHz, the oscillator is operated at an oscillator frequency in the range from 108.5 MHz to 109.82 MHz, and the integer divisor (N1) is set to ten, and the integer multiplier value (M1) is set to unity,
   when the receiver is operated at a reception frequency in the range from 0.53 MHz to 1.71 MHz, the oscillator is operated at an oscillator frequency in the range from 112.3 MHz to 124.1 MHz, and the integer divisor (N1) is set to ten, and the integer multiplier value (M1) is set to unity,
   when the receiver is operated at a reception frequency in the range from 0.513 MHz to 1.62 MHz, the oscillator is operated at an oscillator frequency in the range from 112.13 MHz to 123.2 MHz, and the integer divisor (N1) is set to ten, and the integer multiplier value (M1) is set to unity.

2. Receiver according to Claim 1,
   in which, when the receiver is operated at a reception frequency in the range from 2.3 MHz to 5.06 MHz, the oscillator is operated at an oscillator frequency in the range from 105.0 MHz to 126.08 MHz, and the integer divisor (N1) is set to eight, and the integer multiplier value (M1) is set to unity,
   in which, when the receiver is operated at a reception frequency in the range from 5.9 MHz to 9.9 MHz, the oscillator is operated at an oscillator frequency in the range from 99.6 MHz to 123.6 MHz, and the integer divisor (N1) is set to six, and the integer multiplier value (M1) is set to unity,
   in which, when the receiver is operated at a reception frequency in the range from 11.6 MHz to 21.85 MHz, the oscillator is operated at an oscillator frequency in the range from 89.2 MHz to 130.2 MHz, and the integer divisor (N1) is set to four, and the integer multiplier value (M1) is set to unity,
   in which, when the receiver is operated at a reception frequency in the range from 25.6 MHz to 26.1 MHz, the oscillator is operated at an oscillator frequency in the range from 89.4 MHz to 92.4 MHz, and the integer divisor (N1) is set to six, and the integer multiplier value (M1) is set to unity.

3. Receiver according to Claim 1 or 2,
   in which the multiplier is a mixer.

4. Receiver according to one of Claims 1 to 3,
   in which the divider is a counter.

5. Receiver according to one of Claims 1 to 4,

in which the oscillator is a voltage controlled oscillator.

6. Use of a receiver according to one of Claims 1 to 5 in a radio.


**Revendications**

1. Récepteur pour différentes bandes de fréquences de réception, dans lequel il est prévu un oscillateur (OSZ) qui produit un signal d'oscillateur avec une fréquence d'oscillateur (finput) et dans lequel il est prévu un diviseur de fréquence qui a une valeur de diviseur réelle réglable (TW), qui est branché du côté aval de l'oscillateur et qui divise la fréquence d'oscillateur (finput) par la valeur de diviseur réelle (TW),
**caractérisé par** le fait qui :

le diviseur de fréquence comporte un premier multiplicateur avec une première valeur de multiplicateur entière réglable (M1) et le diviseur de fréquence comporte un premier diviseur avec une première valeur de diviseur entière réglable (N1), le premier multiplicateur et le premier diviseur étant branchés en série,
si le récepteur est exploité avec une fréquence de réception comprise entre 87 MHz et 108 MHz, l'oscillateur est exploité avec une fréquence d'oscillateur comprise entre 97,7 MHz et 118,7 MHz, la valeur de diviseur entière (N1) est réglée sur un et la valeur de multiplicateur entière (M1) est réglée sur un,
si le récepteur est exploité avec une fréquence de réception comprise entre 76 MHz et 91 MHz, l'oscillateur est exploité avec une fréquence d'oscillateur comprise entre 97,95 MHz et 120,45 MHz, la valeur de diviseur entière (N1) est réglée sur trois et la valeur de multiplicateur entière (M1) est réglée sur deux,
si le récepteur est exploité avec une fréquence de réception comprise entre 65,8 MHz et 74 MHz, l'oscillateur est exploité avec une fréquence d'oscillateur comprise entre 114,75 MHz et 127,05 MHz, la valeur de diviseur entière (N1) est réglée sur trois et la valeur de multiplicateur entière (M1) est réglée sur deux,
si le récepteur est exploité avec une fréquence de réception comprise entre 0,15 MHz et 0,282 MHz, l'oscillateur est exploité avec une fréquence d'oscillateur comprise entre 108,5 MHz et 109,82 MHz, la valeur de diviseur entière (N1) est réglée sur dix et la valeur de multiplicateur entière (M1) est réglée sur un,
si le récepteur est exploité avec une fréquence de réception comprise entre 0,53 MHz et 1,71 MHz, l'oscillateur est exploité avec une fréquence d'oscillateur comprise entre 112,3 MHz et 124,1 MHz, la valeur de diviseur entière (N1) est réglée sur dix et la valeur de multiplicateur entière (M1) est réglée sur un,
si le récepteur est exploité avec une fréquence de réception comprise entre 0,513 MHz et 1,62 MHz, l'oscillateur est exploité avec une fréquence d'oscillateur comprise entre 112,13 MHz et 123,2 MHz, la valeur de diviseur entière (N1) est réglée sur dix et la valeur de multiplicateur entière (M1) est réglée sur un.


2. Récepteur selon la revendication 1,
dans lequel, si le récepteur est exploité avec une fréquence de réception comprise entre 2,3 MHz et 5,06 MHz, l'oscillateur est exploité avec une fréquence d'oscillateur comprise entre 105,0 MHz et 126,08 MHz, la valeur de diviseur entière (N1) est réglée sur huit et la valeur de multiplicateur entière (M1) est réglée sur un,
dans lequel, si le récepteur est exploité avec une fréquence de réception comprise entre 5,9 MHz et 9,9 MHz, l'oscillateur est exploité avec une fréquence d'oscillateur comprise entre 99,6 MHz et 123,6 MHz, la valeur de diviseur entière (N1) est réglée sur six et la valeur de multiplicateur entière (M1) est réglée sur un,
dans lequel, si le récepteur est exploité avec une fréquence de réception comprise entre 11,6 MHz et 21,85 MHz, l'oscillateur est exploité avec une fréquence d'oscillateur comprise entre 89,2 MHz et 130,2 MHz, la valeur de diviseur entière (N1) est réglée sur quatre et la valeur de multiplicateur entière (M1) est réglée sur un,
dans lequel, si le récepteur est exploité avec une fréquence de réception comprise entre 25,6 MHz et 26,1 MHz, l'oscillateur est exploité avec une fréquence d'oscillateur comprise entre 89,4 MHz et 92,4 MHz, la valeur de diviseur entière (N1) est réglée sur six et la valeur de multiplicateur entière (M1) est réglée sur un.

3. Récepteur selon la revendication 1 ou 2, dans lequel le multiplicateur est un mélangeur.

4. Récepteur selon l'une des revendications 1 à 3, dans lequel le diviseur est un compteur.

5. Récepteur selon l'une des revendications 1 à 4, dans lequel l'oscillateur est un oscillateur commandable par tension.

6. Utilisation d'un récepteur selon l'une des revendications 1 à 5 dans une radio.

## FIG 1

$f_{Input}$ → [:N1] → $f_{Input}/N1$ → [*M1] → $f_{Input}*M1/N1$

OSZ

## FIG 2

$f_{Input}$ → [*M1] → $f_{Input}*M1$ → [/N1] → $f_{Input}*M1/N1$

OSZ

## FIG 3

$f_{Input}$ → [M1/N1] → $f_{Input}*M1/N1$ → [M2/N2] → $f_{Input}*M1/N1*M2/N2$ → ....... → [Mx/Nx] → $f_{Input}*M1/N1*M2/N2.....*Mx/Nx$

OSZ

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4211975 A

**In der Beschreibung aufgeführte Nicht-Patentliteratur**

- *Gallium Arsenide Integrated Circuit Symposium,* 29. Oktober 1995, 311-314